# EUROPEAN PATENT APPLICATION

(11) **EP 4 768 947 A1**
(43) Date of publication of application: **01.07.2026**
(21) Application number: 25863894.9
(22) Date of filing: 06.08.2025
(51) Int. Cl.: G01R 31/3828, G01R 31/396, G01R 31/392, G01R 31/367, G01R 31/36

(54) **BATTERY DIAGNOSIS DEVICE AND BATTERY DIAGNOSIS METHOD**

(30) Priority: 03.09.2024 KR 20240119261
(71) Applicant: LG Energy Solution, Ltd., Seoul 07335 (KR)
(72) Inventor: KIM, Tae Hyeon, Daejeon 34122 (KR); CHOI, Hyun Jun, Daejeon 34122 (KR); KIM, Young Deok, Daejeon 34122 (KR)
(74) Representative: Goddar, Heinz J.
(86) International application number: PCT/KR2025/011800
(87) International publication number: WO 2026/054344

(57) **Abstract**

According to an embodiment disclosed in this document, there is provided a battery diagnosis device including a memory for storing one or more instructions, and at least one processor, in which the one or more instructions, when executed by the at least one processor, are configured to acquire capacity data and differential capacity data related to a battery cell, identify a first peak and a second peak based on the differential capacity data, identify a capacity range including a state of charge (SOC) corresponding to each of the first peak and the second peak based on the differential capacity data, and estimate a positive electrode capacity loss of the battery cell based on the capacity range.

## Description

### TECHNICAL FIELD

### Cross-reference to Related Applications

This application claims priority from Korean Patent Application No. 10-2024-0119261, filed on September 3, 2024, the disclosure of which is incorporated by reference herein.

### Technical Field

Embodiments disclosed in this document relate to a battery diagnosis device and a battery diagnosis method.

### BACKGROUND ART

The current integration method may be used to estimate the state of health (SOH) of a battery in a battery management system (BMS). The current integration method may refer to an algorithm that estimates the SOH through the degree of shrinkage of battery's voltage data. However, in the case of batteries containing lithium iron phosphate (LFP), errors may occur during SOH estimation due to the potential plateau characteristics of LFP. Therefore, there is a need to study a method for estimating the degree of degradation of a battery cell based on the current integration method independently of the potential plateau characteristics of the LFP.

### DISCLOSURE OF THE INVENTION

### TECHNICAL PROBLEM

Embodiments disclosed in this document provide a battery diagnosis device and a battery diagnosis method for diagnosing the degree of degradation of a battery using a peak value related to a negative electrode material in differential capacity data.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including a memory for storing one or more instructions, and at least one processor, in which the one or more instructions, when executed by the at least one processor, are configured to acquire capacity data and differential capacity data related to a battery cell, identify a first peak and a second peak based on the differential capacity data, identify a capacity range including a state of charge (SOC) corresponding to each of the first peak and the second peak based on the differential capacity data, and estimate a positive electrode capacity loss of the battery cell based on the capacity range.

For example, the one or more instructions, when executed by the at least one processor, may be configured to estimate the positive electrode capacity loss of the battery cell using a first SOC corresponding to the first peak, a second SOC corresponding to the second peak, and a current change amount from a first point in time corresponding to the first peak to a second point in time corresponding to the second peak based on identifying the capacity range.

For example, the one or more instructions, when executed by the at least one processor, may be configured to estimate the positive electrode capacity loss of the battery cell based on a current integration method.

For example, the one or more instructions, when executed by the at least one processor, may be configured to identify an available lithium loss of the battery cell using a total capacity loss of the battery cell and the positive electrode capacity loss of the battery cell.

For example, the one or more instructions, when executed by the at least one processor, may be configured to verify the positive electrode capacity loss of the battery cell and the available lithium loss of the battery cell based on cell disassembly analysis.

For example, the battery cell may contain a positive electrode material and a negative electrode material, and the one or more instructions, when executed by the at least one processor, may be configured to identify the first peak and the second peak generated based on the negative electrode material among the positive electrode material and negative electrode material.

For example, the positive electrode material may contain lithium iron phosphate (LFP).

For example, the capacity data may represent the capacity of the battery cell relative to the voltage of the battery cell, and the differential capacity data may represent a capacity change in the battery cell with respect to a voltage change in the battery cell.

According to another embodiment disclosed in this document, there is provided a battery diagnosis method including an operation of acquiring capacity data and differential capacity data related to a battery cell, an operation of identifying a first peak and a second peak based on the differential capacity data, an operation of identifying a capacity range including a state of charge (SOC) corresponding to each of the first peak and the second peak based on the differential capacity data, and an operation of estimating a positive electrode capacity loss of the battery cell based on the capacity range.

For example, the operation of estimating a positive electrode capacity loss of the battery cell may include an operation of estimating the positive electrode capacity loss of the battery cell using a first SOC corresponding to the first peak, a second SOC corresponding to the second peak, and a current change amount from a first point in time corresponding to the first peak to a second point in time corresponding to the second peak based on identifying the capacity range.

For example, the operation of estimating the positive electrode capacity loss of the battery cell may include an operation of estimating the positive electrode capacity loss of the battery cell based on a current integration method.

For example, the operation of estimating the positive electrode capacity loss of the battery cell may further include an operation of identifying an available lithium loss of the battery cell using a total capacity loss of the battery cell and the positive electrode capacity loss of the battery cell.

For example, the operation of identifying the available lithium loss of the battery cell may further include an operation of verifying the positive electrode capacity loss of the battery cell and the available lithium loss of the battery cell based on cell disassembly analysis.

For example, the battery cell may include a positive electrode material and a negative electrode material, and the operation of identifying a first peak and a second peak may include an operation of identifying the first peak and the second peak generated based on the negative electrode material among the positive electrode material and negative electrode material.

For example, the positive electrode material may contain lithium iron phosphate (LFP).

### ADVANTAGEOUS EFFECTS

The battery diagnosis device and battery diagnosis method according to the embodiments disclosed in this document can diagnose the degree of degradation of a battery using a peak value related to a negative electrode material in differential capacity data.

In addition, various effects that are directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram showing the configuration of a battery diagnosis device according to an embodiment disclosed in this document.
FIG. 3a illustrates an example of a graph showing voltage with respect to capacity of a battery cell according to an embodiment disclosed in this document.
FIG. 3b illustrates an example of a graph showing voltage with respect to capacity of a positive electrode material included in a battery cell according to an embodiment disclosed in this document.
FIG. 4a illustrates an example of a graph showing capacity change with respect to voltage change of a battery cell according to an embodiment disclosed in this document.
FIG. 4b illustrates an example of a graph showing a capacity change with respect to a voltage change of a negative electrode material included in a battery cell according to an embodiment disclosed in this document.
FIG. 5 illustrates an example of a graph showing voltage change with respect to capacity change of a battery cell according to an embodiment disclosed in this document.
FIG. 6 illustrates an example of a graph representing voltage with respect to a state of charge (SOC) of a battery cell according to an embodiment disclosed in this document.
FIG. 7 is a flowchart illustrating an operation performed by a battery diagnosis device according to an embodiment disclosed in this document.
FIG. 8 illustrates a computing system executing a battery diagnosis method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

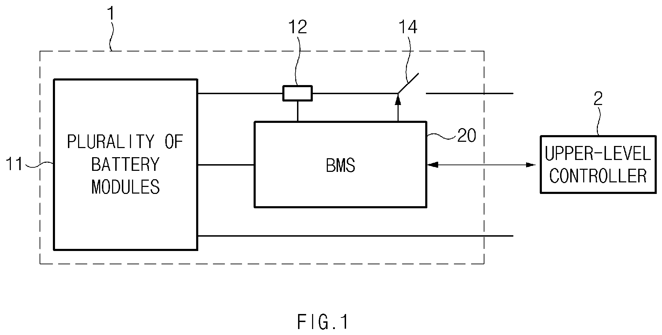

FIG. 1 is a block diagram showing a battery pack according to an embodiment disclosed in this document.

Referring to FIG. 1, a battery control system including a battery pack 1 and an upper-level controller 2 included in an upper-level system according to an embodiment disclosed in this document is schematically illustrated.

As illustrated in FIG. 1, the battery pack 1 may include a plurality of battery modules 11, a switching unit 14 connected in series to a first terminal side and/or a second terminal side of the plurality of battery modules 11 to control a charge and/or discharge current flow of the plurality of battery modules 11, and a battery management system 20 that monitors the voltage, current, temperature, etc. of the battery pack 1 to prevent overcharging and overdischarging.

In this case, the battery pack 1 may be equipped with a plurality of the plurality of modules 11, sensors 12, switching units 14, and battery management systems 20. For example, a first terminal may be a positive (+) terminal of the plurality of battery modules 11, and a second terminal may be a negative (-) terminal thereof.

Here, the switching unit 14 is a device for controlling the current flow for charging or discharging the plurality of battery modules 11, and for example, at least one relay, magnetic contactor, etc. may be used depending on the specifications of the battery pack 1.

The plurality of battery modules 11 may include one or more cells. For example, the plurality of battery modules 11 may include a cylindrical battery. The cylindrical battery may refer to a battery in which battery materials are packaged in a cylindrical shape. Since the plurality of battery modules 11 include cylindrical batteries, if lithium deposition occurs inside the cylindrical batteries during constant voltage charging of the plurality of battery modules 11, a phenomenon in which the current flowing through the plurality of battery modules 11 increases may occur.

The battery management system 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of the plurality of battery modules 11.

The upper-level controller 2 may transmit a control signal for the plurality of battery modules 11 to the battery management system 20. Accordingly, the operation of the battery management system 20 may be controlled based on a signal applied from the upper-level controller 2.

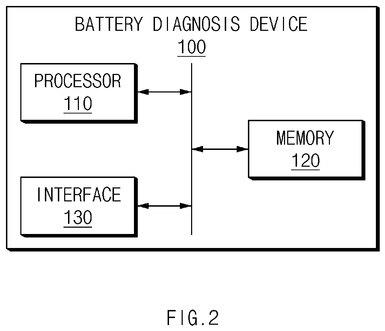

According to the embodiment, the battery management system 20 may include a battery diagnosis device 100 of FIG. 2. According to another embodiment, the battery management system 20 may be another system different from the battery diagnosis device 100 of FIG. 2. That is, the battery diagnosis device 100 of FIG. 2 may be included in the battery pack 1 or may be configured as another device external to the battery pack 1. For convenience of description, it will be described on the premise that the battery diagnosis device 100 is configured as another device external to the battery pack 1.

FIG. 2 is a block diagram illustrating the configuration of a battery diagnosis device according to an embodiment disclosed in this document.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto, some of the pieces of hardware of FIG. 1 (e.g., at least a portion of the processor 110, memory 120, and communication circuity (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery diagnosis device 100 according to an embodiment may include hardware components for storing data and/or instructions input and/or output to and from the processor 110. The memory 220 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC).

The interface 130 of the battery diagnosis device 100 according to an embodiment may be configured to generate battery measurement values from a battery. To this end, the interface 130 may include a measuring means such as a voltmeter, an ammeter, a thermometer, etc., and/or a communication circuit for establishing a communication link with an external device.

For example, the interface 130 may be configured to collect battery data from the battery. The battery data may include capacity data and differential capacity data.

For example, capacity data may include data representing a voltage relative to a capacity of a battery cell and/or data representing the capacity of the battery cell with respect to the voltage of the battery cell. For example, capacity data may represent the voltage relative to the state of charge (SOC) of a battery cell.

For example, differential capacity data may include data representing a capacity change of a battery cell with respect to a voltage change in the battery cell and/or data representing a voltage change relative to a capacity change in the battery cell.

For example, a test voltage or current by a charger/discharger may be applied to the battery, and the interface 130 may measure the response of the battery according to the test voltage.

The processor 110 according to an embodiment may acquire capacity data and differential capacity data related to the battery cell (at least one of the battery cells included in the plurality of battery modules 11 of FIG. 1) through the interface 130.

For example, the capacity data and differential capacity data may represent data for the entire battery cell. The capacity data and differential capacity data may represent data for at least one material contained in the battery cell.

For example, a battery cell may contain a positive electrode material and a negative electrode material. The positive electrode material may include lithium iron phosphate (LFP). The negative electrode material may include graphite.

The processor 110 according to an embodiment may identify a first peak and a second peak based on the differential capacity data. For example, the processor 110 may identify the first peak and the second peak generated based on the negative electrode material among the positive electrode material and the negative electrode material.

For example, the first peak and the second peak may be related to the negative electrode material of the battery cell. The first peak and the second peak may be generated based on the electrochemical properties of the negative electrode material. For example, the first peak and the second peak may represent local extrema contained in the differential capacitance data. For example, a value representing the slope of the differential capacity data may change from a positive number to a negative number with the first peak as a reference. However, it is not limited thereto.

The processor 110 according to an embodiment may identify the state of charge (SOC) corresponding to each of the first peak and the second peak based on capacity data. For example, the processor 110 may can identify a capacity range that includes the SOC. The processor 110 may estimate a positive electrode capacity loss of the battery cell based on the capacity range. The positive electrode capacity loss may be referred to as a positive electrode capacity loss rate in terms of an amount of capacity of positive electrode lost from the capacity of the positive electrode in the battery cell in the BOL state.

The processor 110 according to an embodiment may estimate the positive electrode capacity loss based on a current integration method. For example, the current integration method may be an example of an algorithm for estimating the SOH or positive electrode capacity loss of a battery cell.

For example, the processor 110 may estimate the positive electrode capacity loss of the battery cell using a first SOC corresponding to the first peak, a second SOC corresponding to the second peak, and a current change amount from a first point in time corresponding to the first peak to a second point in time corresponding to the second peak based on identifying the capacity range.

For example, the positive electrode capacity loss may refer to a phenomenon in which the overall capacity of a battery cell is lost due to a change occurring at the positive electrode of the battery cell. The positive electrode capacity loss may occur due to a change in the crystal structure of the positive electrode active material of the battery cell. The positive electrode capacity loss may occur due to chemical reactions between the positive electrode material and the electrolyte.

For example, the total capacity loss of a battery cell may include both positive electrode capacity loss and available lithium loss. The available lithium loss may indicate a phenomenon in which the amount of lithium ions that may participate in electrochemical reactions within the battery cell.

For example, the processor 110 may estimate the available lithium loss, which indicates the amount of lithium ions reduced within the battery cell, based on an estimating the positive electrode capacity loss, which indicates the amount of positive electrode capacity lost.

The processor 110 according to an embodiment may verify the positive electrode capacity loss and available lithium loss based on cell disassembly analysis. The cell disassembly analysis may refer to a method of physically disassembling a battery cell to evaluate (or identify) the condition of its internal components.

The battery diagnosis device 100 according to an embodiment as described above may set a capacity range for identifying the positive electrode capacity loss of the battery cell based on the current integration method. The battery diagnosis device 100 may set the capacity range using the peaks related to the negative electrode material. The battery diagnosis device 100 may identify the positive electrode capacity loss and available lithium loss of a battery cell based on setting the capacity range. The battery diagnosis device 100 may diagnose the state of the battery cell based on identifying the positive electrode capacity loss and the available lithium loss. The battery diagnosis device 100 may identify the degree of degradation of the battery cell based on identifying the positive electrode capacity loss and the available lithium loss. The battery diagnosis device 100 may improve the accuracy (or reliability) of the degree of degradation of the battery cell by setting the capacity range.

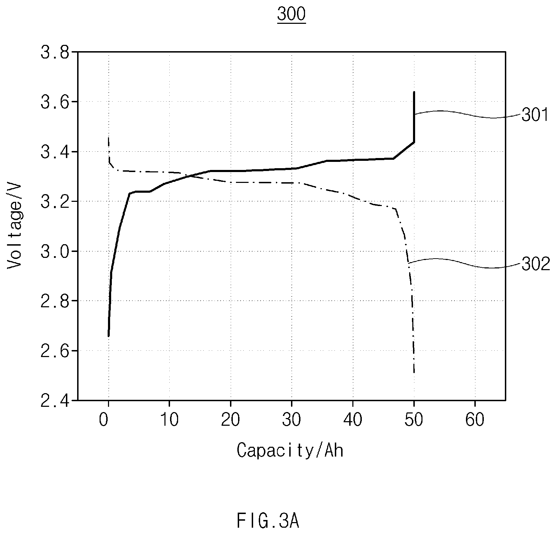

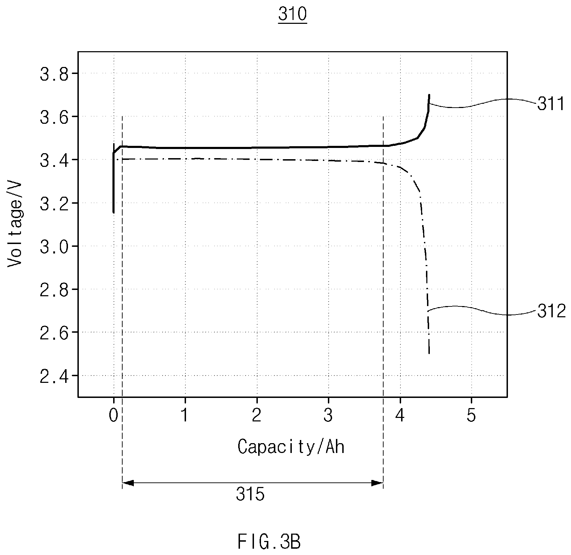

FIG. 3a illustrates an example of a graph showing voltage with respect to capacity of a battery cell according to an embodiment disclosed in this document. FIG. 3b illustrates an example of a graph showing voltage with respect to capacity of a positive electrode material included in a battery cell according to an embodiment disclosed in this document. The battery diagnosis device 100 of FIGS. 3a and 3b may be may be referenced to the battery diagnostic device 100 of FIG. 2.

Referring to FIG. 3a, a graph 300 may represent capacity data representing the voltage of a battery cell with respect to the capacity of the battery cell obtained by the battery diagnosis device 100 according to an embodiment. The graph 300 may include charge capacity data 301 and discharge capacity data 302. The charge capacity data 301 may represent a charge profile acquired while charging a battery cell. The discharge capacity data 302 may represent a discharge profile acquired while discharging the battery cell.

Referring to the graph 300, in the battery diagnosis device 100 according to an embodiment, a peak representing the characteristics of the positive electrode material containing LFP may not be included in the capacity data. The capacity data may have a form similar to that of the positive electrode material containing LFP.

Referring to FIG. 3b, an example of a graph 310 indicating the characteristics of the LFP is illustrated. The graph 310 may represent capacity data representing voltage with respective to capacity of a battery including the LFP. The graph 310 may include charge capacity data 311 and discharge capacity data 312. The charge capacity data 311 may represent a charge profile acquired while charging the LFP, and the discharge capacity data 312 may represent a discharge profile acquired while discharging the LFP.

Referring to the graph 310, the charge capacity data 311 and the discharge capacity data 312 may exhibit plateau characteristics within a designated range. The designated range may refer to a potential plateau curve. The designated range may represent the capacity range corresponding to designated potential (e.g., 3.4 V). Since the LFP has the plateau characteristic within the designated range, referring to the graph 300 of FIG. 3a, the capacity data of the battery cell having the positive electrode material including the LFP may not have a peak.

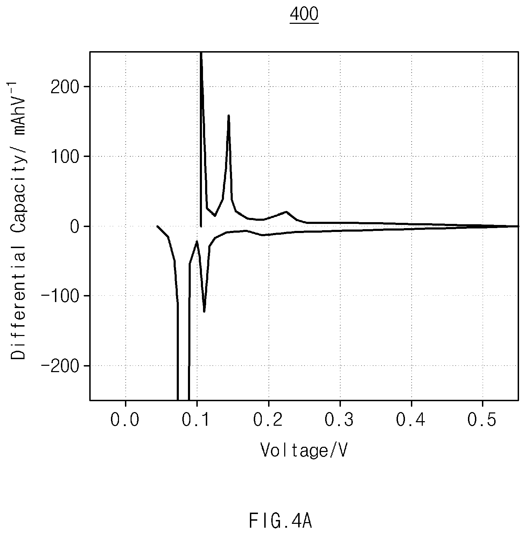

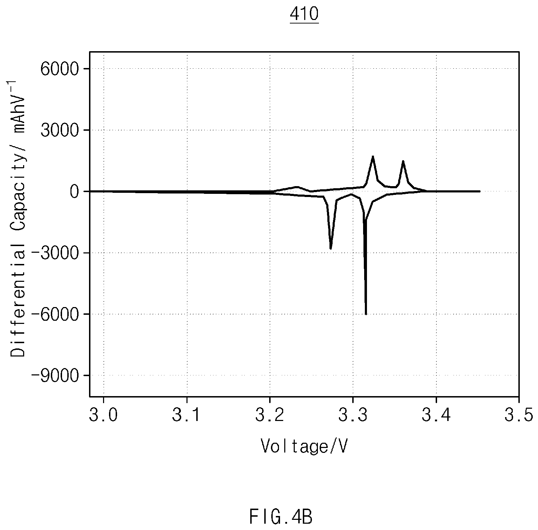

The battery diagnosis device 100 according to an embodiment may identify the peak using the differential capacity data when the battery diagnosis device 100 cannot identify the peak in the capacity data. Hereinafter, with reference to FIGS. 4a and 4b, an operation in which the battery diagnosis device 100 sets a capacity range for identifying the positive electrode capacity loss based on the current integration method using the differential capacity data will be described in more detail.

FIG. 4a illustrates an example of a graph showing a capacity change with respect to a voltage change of a battery cell according to an embodiment disclosed in this document. FIG. 4b illustrates an example of a graph showing a capacity change with respect to a voltage change of a negative electrode material contained in a battery cell according to an embodiment disclosed in this document. The battery diagnosis device 100 of FIGS. 4a and 4b may be referenced to the battery diagnosis device 100 of FIG. 2.

Referring to FIG. 4a, a graph 400 may represent differential capacity data representing a capacity change with respect to a voltage change of a battery cell. The differential capacity data may be acquired based on the characteristics of the negative electrode material among the positive electrode material including the LFP and the negative electrode material including graphite.

Referring to FIG. 4b, a graph 410 may represent differential capacity data based on the negative electrode material including graphite. Referring to the graphs 400 and 410, the form of the differential capacity data of the battery cell may be similar to the form of the differential capacity data based on the negative electrode material. That is, in the differential capacity data of the battery cell, the battery diagnosis device 100 may identify characterization peaks generated by the negative electrode material.

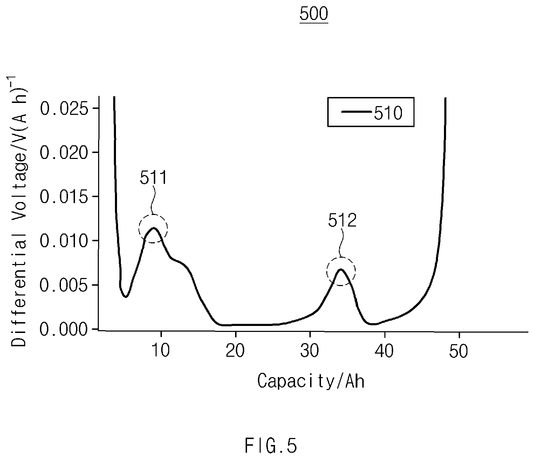

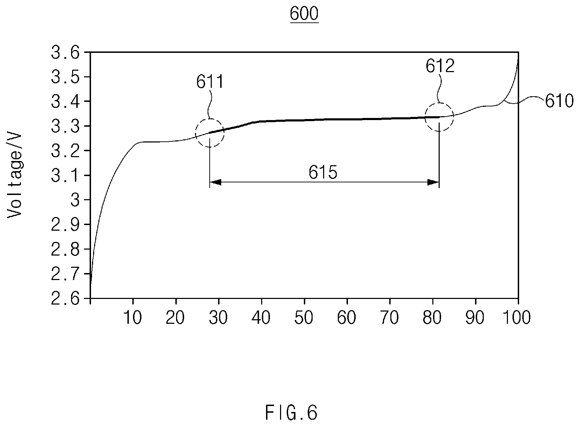

Hereinafter, with reference to FIGS. 5 and 6, an operation in which the battery diagnosis device 100 identifies a peak will be described later

FIG. 5 illustrates an example of a graph showing voltage change with respect to capacity change of a battery cell according to an embodiment disclosed in this document. FIG. 6 illustrates an example of a graph representing voltage with respect to the state of charge (SOC) of the battery cell according to an embodiment disclosed in this document. The battery diagnosis device 100 of FIGS. 5 and 6 may be referenced to the battery diagnosis device 100 of FIG. 2. Referring to FIG. 5, a graph 500 may include differential capacity data (or dQ/dV data) 510 representing a voltage change of a battery cell with respect to a capacity change in the battery cell. Referring to FIG. 6, a graph 600 may include voltage data 610 representing a voltage with respect to the SOC of a battery cell.

In an embodiment, in the differential capacity data 510, one or more peaks 511 and 512 may be identified. For example, the battery diagnosis device 100 may identify a first peak 511 and a second peak 512. For example, the battery diagnosis device 100 may identify a first capacity of the battery cell corresponding to the first peak 511 and a second capacity of the battery cell corresponding to the second peak 512. For example, the battery diagnosis device 100 may identify a first SOC corresponding to the first capacity and a second SOC corresponding to the second capacity.

Referring to FIG. 6, the battery diagnosis device 100 according to an embodiment may identify a first voltage 611 corresponding to the first SOC and a second voltage 612 corresponding to the second SOC in voltage data 610. The first voltage 611 may correspond to the first peak. The second voltage 612 may correspond to the second peak.

The battery diagnosis device 100 according to an embodiment may identify (or set) a capacity range 615 based on identifying the first voltage 611 and the second voltage 612. The battery diagnosis device 100 may estimate the positive electrode capacity loss of the battery cell according to the current integration method based on identifying the capacity range 615.

For example, the battery diagnosis device 100 may estimate the positive electrode capacity loss of the battery cell by using the first SOC, the second SOC, and a current change amount from a first point in time corresponding to the first peak to a second point in time corresponding to the second peak based on identifying the capacity range 615.

The battery diagnosis device 100 according to an embodiment may identify data indicating the total capacity loss of the battery cell based on estimating the positive electrode capacity loss. The battery diagnosis device 100 may identify data representing the total capacity loss of the battery cell stored in the memory (e.g., the memory 120 of FIG. 2). The battery diagnosis device 100 may acquire data indicating the total capacity loss of the battery cell from an external electronic device.

The battery diagnosis device 100 according to an embodiment may identify the available lithium loss of the battery cell by using the total capacity loss and the positive electrode capacity loss. For example, the total capacity loss may indicate the degree of degradation of the battery cell. The battery diagnosis device 100 may identify the available lithium loss by using the difference between the total capacity loss and the positive electrode capacity loss.

For example, the battery diagnosis device 100 may control the battery based on identifying the positive electrode capacity loss and the available lithium loss. For example, the battery diagnosis device 100 may adjust the amount of charge of the battery cell or the amount of discharge of the battery cell based on the positive electrode capacity loss and the available lithium loss. For example, the battery diagnosis device 100 may provide information indicating the positive electrode capacity loss and the available lithium loss to an external device. As an example, the battery diagnosis device 100 may display the information the positive electrode capacity loss and the available lithium loss a display (not shown).

The battery diagnosis device 100 according to an embodiment may verify the positive electrode capacity loss and the available lithium loss by comparing the positive electrode capacity loss and the available lithium loss with reference data acquired through cell disassembly analysis based on identifying the positive electrode capacity loss and the available lithium loss. For example, the battery diagnosis device 100 may provide a result of verifying the positive electrode capacity loss and the available lithium loss to an external device.

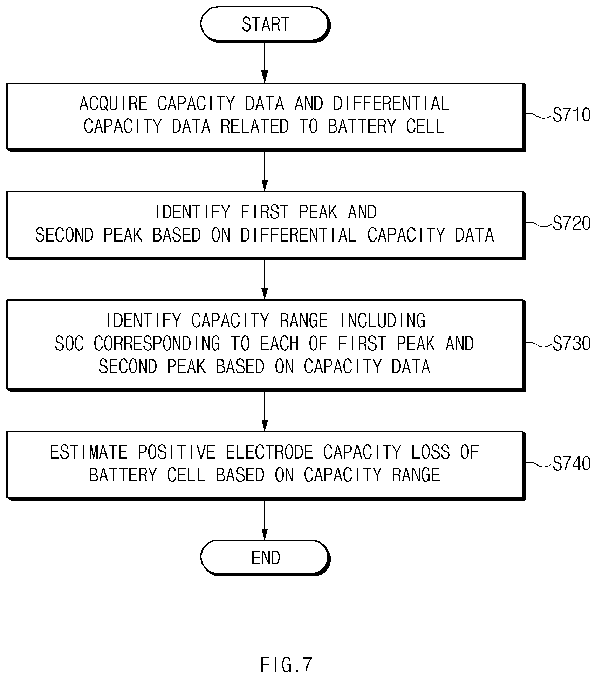

FIG. 7 is a flowchart illustrating an operation performed by a battery diagnosis device according to an embodiment disclosed in this document.

FIG. 7 is a flowchart illustrating a battery diagnosis method according to an embodiment disclosed in this document. Hereinafter, it is assumed that the battery diagnosis device 100 of FIG. 2 performs the process of FIG. 7. In addition, the operations described as being performed by the device may be understood to be controlled by the processor 110 of the battery diagnosis device 100. Each of the operations in FIG. 7 may be performed sequentially, but is not necessarily performed sequentially. For example, the order of each of the operations may be changed, and at least two operations may be performed in parallel. In addition, the operation of the battery diagnosis device 100 below may be performed by a battery management system (BMS) in a vehicle, and may also be performed in various devices such as a server, cloud, charger, or charger/discharger.

Referring to FIG. 7, in operation S710, the battery diagnosis device according to an embodiment may acquire capacity data and differential capacity data related to a battery cell. The format of the capacity data may reflect the characteristics of the positive electrode material, including the LFP. The differential capacity data may reflect the characteristics of the negative electrode material, including graphite.

Referring to FIG. 7, in operation S720, the battery diagnosis device according to an embodiment may identify a first peak (e.g., the first peak 511 of FIG. 5) and a second peak (e.g., the second peak 512 of FIG. 5) based on the differential capacity data.

Referring to FIG. 7, in operation S730, the battery diagnosis device according to an embodiment may identify a capacity range (e.g., the capacity range 615 of FIG. 6) including an SOC corresponding to each of the first peak and the second peak based on the capacity data. The capacity range may include a range for acquiring the positive electrode capacity loss of the battery cell based on the current integration method.

Referring to FIG. 7, in operation S740, the battery diagnosis device according to an embodiment may estimate the positive electrode capacity loss of the battery cell based on the capacity range.

For example, the battery diagnosis device may acquire the difference between the total capacity loss and the positive electrode capacity loss of a battery cell based on estimating the positive electrode capacity loss of the battery cell. The difference between the total capacity loss and positive electrode capacity loss may be referred to as available lithium loss.

For example, the battery diagnosis device may control at least one of charging or discharging of the battery when at least one of the positive electrode capacity loss and the available lithium loss exceeds a designated threshold. For example, the battery diagnostic device may control the charging speed of a battery cell. For example, the battery diagnosis device may adjust the amount of charge (or discharge) of the battery cell, but is not limited thereto.

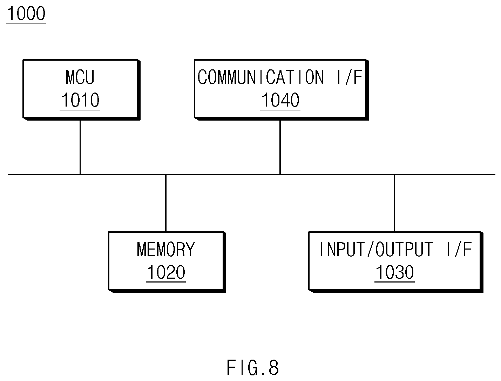

FIG. 8 illustrates a computing system executing a battery diagnosis method according to an embodiment disclosed in this document.

Referring to FIG. 8, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data, including the state of charge (SOC) and state of health (SOH) of a plurality of battery cells through these programs, and performs the functions of the battery diagnosis device 100 described with reference to FIGS. 2 to 6. The MCU 1010 may be, but is not limited to, a BMS, a separate PC, or the cloud.

The memory 1020 may store various programs related to calculating the SOH of battery cells and determining the target for which cell balancing is performed. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, programs or various data for calculating the SOH of a battery cell or determining a balancing target may be transmitted to and received from a separately provided external server through the communication I/F 1040.

In this way, the battery diagnosis method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
a memory for storing one or more instructions; and
at least one processor,
wherein the one or more instructions, when executed by the at least one processor, are configured to:
acquire capacity data and differential capacity data related to a battery cell;
identify a first peak and a second peak based on the differential capacity data;
identify a capacity range including a state of charge (SOC) corresponding to each of the first peak and the second peak based on the differential capacity data; and
estimate a positive electrode capacity loss of the battery cell based on the capacity range.

2. The battery diagnosis device of claim 1, wherein the one or more instructions, when executed by the at least one processor, are configured to estimate the positive electrode capacity loss of the battery cell using a first SOC corresponding to the first peak, a second SOC corresponding to the second peak, and a current change amount from a first point in time corresponding to the first peak to a second point in time corresponding to the second peak based on identifying the capacity range.

3. The battery diagnosis device of claim 1, wherein the one or more instructions, when executed by the at least one processor, are configured to estimate the positive electrode capacity loss of the battery cell based on a current integration method.

4. The battery diagnosis device of claim 1, wherein the one or more instructions, when executed by the at least one processor, are configured to identify an available lithium loss of the battery cell using a total capacity loss of the battery cell and the positive electrode capacity loss of the battery cell.

5. The battery diagnosis device of claim 4, wherein the one or more instructions, when executed by the at least one processor, are configured to verify the positive electrode capacity loss of the battery cell and the available lithium loss of the battery cell based on cell disassembly analysis.

6. The battery diagnosis device of claim 1, wherein the battery cell contains a positive electrode material and a negative electrode material, and
the one or more instructions, when executed by the at least one processor, are configured to identify the first peak and the second peak generated based on the negative electrode material among the positive electrode material and negative electrode material.

7. The battery diagnosis device of claim 6, wherein the positive electrode material may contain lithium iron phosphate (LFP).

8. The battery diagnosis device of claim 1, wherein the capacity data represents the capacity of the battery cell relative to the voltage of the battery cell, and
the differential capacity data represents a capacity change in the battery cell with respect to a voltage change in the battery cell.

9. A battery diagnosis method comprising:
an operation of acquiring capacity data and differential capacity data related to a battery cell;
an operation of identifying a first peak and a second peak based on the differential capacity data;
an operation of identifying a capacity range including a state of charge (SOC) corresponding to each of the first peak and the second peak based on the differential capacity data; and
an operation of estimating a positive electrode capacity loss of the battery cell based on the capacity range.

10. The battery diagnosis method of claim 9, wherein the operation of estimating a positive electrode capacity loss of the battery cell includes an operation of estimating the positive electrode capacity loss of the battery cell using a first SOC corresponding to the first peak, a second SOC corresponding to the second peak, and a current change amount from a first point in time corresponding to the first peak to a second point in time corresponding to the second peak based on identifying the capacity range.

11. The battery diagnosis method of claim 9, wherein the operation of estimating the positive electrode capacity loss of the battery cell includes an operation of estimating the positive electrode capacity loss of the battery cell based on a current integration method.

12. The battery diagnosis method of claim 9, wherein the operation of estimating the positive electrode capacity loss of the battery cell further includes an operation of identifying an available lithium loss of the battery cell using a total capacity loss of the battery cell and the positive electrode capacity loss of the battery cell.

13. The battery diagnosis method of claim 12, wherein the operation of identifying the available lithium loss of the battery cell further includes an operation of verifying the positive electrode capacity loss of the battery cell and the available lithium loss of the battery cell based on cell disassembly analysis.

14. The battery diagnosis method of claim 9, wherein the battery cell contains a positive electrode material and a negative electrode material, and
the operation of identifying a first peak and a second peak includes an operation of identifying the first peak and the second peak generated based on the negative electrode material among the positive electrode material and negative electrode material.

15. The battery diagnosis method of claim 9, wherein the positive electrode material contains lithium iron phosphate (LFP).
